# EUROPÄISCHE PATENTSCHRIFT

(11) **EP 2 153 187 B1**
(45) Veröffentlichungstag und Bekanntmachung des Hinweises auf die Patenterteilung: **16.01.2013**
(21) Anmeldenummer: 08758829.9
(22) Anmeldetag: 28.05.2008
(51) Int. Cl.: G01J 5/34, G01J 5/04

(54) **VORRICHTUNG MIT MEMBRANSTRUKTUR ZUR DETEKTION VON WÄRMESTRAHLUNG, VERFAHREN ZUM HERSTELLEN UND VERWENDUNG DER VORRICHTUNG**
DEVICE HAVING A MEMBRANE STRUCTURE FOR DETECTING THERMAL RADIATION, METHOD OF PRODUCTION AND USE OF THE DEVICE
DISPOSITIF À STRUCTURE DE MEMBRANE CONÇU POUR DÉTECTER UN RAYONNEMENT THERMIQUE, PROCÉDÉ DE FABRICATION ET UTILISATION DU DISPOSITIF

(30) Priorität: 29.05.2007 DE 102007024902
(43) Veröffentlichungstag der Anmeldung: 17.02.2010
(73) Patentinhaber: Pyreos Ltd., EH9 3JF Edinburgh (GB)
(72) Erfinder: GIEBELER, Carsten, Edinburgh (DE); SCHREITER, Matthias, 81379 München (DE); PAULUS, Christian, 82362 Weilheim (DE)
(74) Vertreter: Fischer, Ernst
(86) Internationale Anmeldenummer: PCT/EP2008/004246
(87) Internationale Veröffentlichungsnummer: WO 2008/145353

(56) Entgegenhaltungen:
- WO-A-2007/000172
- WO-A-2007/054111
- US-A1- 2006 208 189

## Beschreibung

Die Erfindung betrifft eine Vorrichtung zur Detektion von Wärmestrahlung mit mindestens einem thermischen Detektorelement zur Umwandlung der Wärmestrahlung in ein elektrisches Signal. Neben der Vorrichtung werden ein Verfahren zur Herstellung der Vorrichtung und eine Verwendung der Vorrichtung angegeben.

Eine Vorrichtung zur Detektion von Wärmestrahlung ist beispielsweise aus DE 100 04 216 A1 bekannt. Diese Vorrichtung wird als Pyrodetektor bezeichnet. Das Detektorelement ist ein pyroelektrisches Detektorelement. Es weist einen Schichtaufbau mit zwei Elektrodenschichten und einer zwischen den Elektrodenschichten angeordneten pyroelektrischen Schicht mit pyroelektrisch sensitivem Material auf. Dieses Material ist Bleizirkonattitanat (PZT). Die Elektroden bestehen beispielsweise aus Platin oder aus einer die Wärmestrahlung absorbierenden Chrom-Nickel-Legierung.

Das thermische Detektorelement ist mit einem Detektorträger aus Silizium(Silizium-Wafer) verbunden. Zwischen dem Detektorelement und dem Detektorträger ist eine Isolationsschicht zur elektrischen und thermischen Isolierung des Detektorelements und des Detektorträgers voneinander angeordnet. Die Isolationsschicht verfügt dabei über einen evakuierten Hohlraum, der sich über eine Grundfläche des Detektorelements hinweg erstreckt, eine Stützschicht des Hohlraums und eine Abdeckung der Stützschicht und des Hohlraums. Die Stützschicht besteht aus Polysilizium. Die Abdeckung ist aus einem Bor-Phosphor-Silikat-Glas (BPSG). Zum Auslesen, Verarbeiten und/oder Weiterleiten des vom Detektorelement erzeugten elektrischen Signals ist im Detektorträger ein Ausleseschaltkreis integriert. Der Ausleseschaltkreis ist durch die CMOS(Complementary Metalloxide Semiconductors)-Technik realisiert.

Eine damit vergleichbare Vorrichtung zur Detektion von Wärmestrahlung ist aus der DE 195 25 071 A1 bekannt. Das thermische Detektorelement ist ebenfalls ein oben beschriebenes pyroelektrisches Detektorelement. Das Detektorelement ist auf einem mehrschichtigen Detektorträger angeordnet. Über eine seiner Elektrodenschichten ist das Detektorelement auf einer Siliziumschicht des Detektorträgers aufgebracht. Die Siliziumschicht befindet sich auf einer elektrisch isolierenden Membran des Detektorträgers. Die Membran besteht beispielsweise aus einer Si₃N₄/SiO₂/Si₃N₄ - Dreifach-Schicht. Die Membran ist wiederum auf einem Silizium-Substrat des Detektorträgers aufgebracht. Das Silizium-Substrat weist ein Bestrahlungsfenster (Detektionsfenster) auf mit einer Grundfläche, die im Wesentlichen einer Grundfläche des pyroelektrischen Detektorelements entspricht. Das Bestrahlungsfenster ist ein Ausschnitt des Silizium-Substrats. Dabei ist Trägermaterial (Silizium) des Substrats bis zur Membran hin entfernt. Durch das Bestrahlungsfenster gelangt die Wärmestrahlung auf das Detektorelement und führt dort zu einem auswertbaren elektrischen Signal. Dazu zeichnet sich die Membran durch eine geeignete Transmission für die Wärmestrahlung aus. In der Siliziumschicht, seitlich zum Detektorelement versetzt, ist ein Ausleseschaltkreis für das elektrische Signal integriert. Der Detektorträger fungiert auch als Schaltungsträger des Ausleseschaltkreises.

Bei den bekannten Vorrichtungen kann eine Vielzahl von Detektorelementen vorhanden sein (Detektorelement-Array). Dabei ist das elektrische Signal jedes der Detektorelemente separat auszulesen. Üblicherweise sind dazu die Elektrodenschichten jedes der Detektorelemente über Bonddrähte elektrisch kontaktiert. Dies bedeutet aber einen erheblichen Platzbedarf für eine Verdrahtung der Detektorelemente mit dem Ergebnis einer begrenzten, relativ niedrigen Detektorelement-Dichte (Anzahl der Detektorelemente pro Oberflächenabschnitt des Detektorträgers).

In WO 2007/000172 A1 ist eine Vorrichtung zur Detektion von elektromagnetischen Wellen beschrieben, wobei die Vorrichtung von drei Platten und einer Membran gebildet ist, an der eine Detektorstruktur befestigt ist. In WO 2007/054111 A1 ist ein Sensor zum Erfassen einer elektromagnetischen Strahlung beschrieben, der eine Sensormembran mit einer Halbleiterschicht aufweist.

Aufgabe der Erfindung ist es, eine kompakte Vorrichtung zur Detektion von Wärmestrahlung anzugeben, die einen im Vergleich zum Stand der Technik geringeren Platzbedarf aufweist.

Die Aufgabe wird gelöst mit den Merkmalen der Patentansprüche 1 und 9. Bevorzugte Ausgestaltungen dazu sind in den weiteren Patentansprüchen angegeben.

Zur Lösung der Aufgabe wird eine Vorrichtung zur Detektion von Wärmestrahlung gemäß dem Patentanspruch 1 angegeben. Die Vorrichtung weist mindestens eine Membran, auf der mindestens ein thermisches Detektorelement zur Umwandlung der Wärmestrahlung in ein elektrisches Signal angeordnet ist, und mindestens einen Schaltungsträger zum Tragen der Membran und zum Tragen mindestens einer Ausleseschaltung zum Auslesen des elektrischen Signals auf, wobei das Detektorelement und die Ausleseschaltung über eine elektrische Durchkontaktierung durch die Membran hindurch elektrisch miteinander verbunden sind.

Zur Lösung der Aufgabe wird auch ein Verfahren zum Herstellen der Vorrichtung gemäß dem Patentanspruch 9 angegeben. Das Verfahren weist insbesondere die Verfahrensschritte auf: a) Bereitstellen der Membran mit dem Detektorelement und mindestens einer elektrischen Durchkontaktierung und Bereitstellen des Schaltungsträgers und b) Zusammenbringen der Membran und des Schaltungsträgers derart, dass das Detektorelement und die Ausleseschaltung über eine elektrische Durchkontaktierung durch die Membran hindurch elektrisch miteinander verbunden sind.

Die Membran, die als Detektorträger fungiert, besteht aus einer Membranschicht oder aus mehreren Membranschichten. Dabei kann eine Vielzahl von anorganischen oder organischen Materialien eingesetzt werden. Beispielsweise ist die Membranschicht aus Siliziumdioxid (Si02) oder Siliziumnitrid (Si3N4). Denkbar ist auch ein Verbund aus mehreren der genannten Schichten. Der besondere Vorteil an Schichten aus diesen Materialien liegt in der elektrischen und thermischen Isolationswirkung der Materialien. Diese Materialien fungieren als elektrischer und thermischer Isolator.

Durch die Erfindung wird eine kompakte, Platz sparende mehrschichtige Struktur aus Membran und Schaltungsträger realisiert. Der Auswerteschaltkreis kann direkt im Schaltungsträger integriert sein, beispielsweise durch die CMOS-Technik. Denkbar ist auch, dass der Schaltungsträger lediglich eine Verdrahtung des Detektorelements bereitstellt. Durch die Verdrahtung ist das Detektorelement mit einem im Schaltungsträger angeordneten internen ASIC (Applied Specific Integrated Circuit, anwendungsspezifische integrierte Schaltung) oder mit einem externen ASIC elektrisch verbunden. Das externe ASIC kann gebondet sein. Vorteilhaft ist das externe ASIC mittels "Flip Chip"-Technik (Siehe unten) kontaktiert.

Die zu detektierende Wärmestrahlung weist eine Wellenlänge von über 1 µm auf. Vorzugsweise ist die Wellenlänge aus dem Bereich von 5 bis 15 µm ausgewählt. Das thermische Detektorelement basiert beispielsweise auf dem Seebeck-Effekt. Vorzugsweise ist das thermische Detektorelement ein pyroelektrisches Detektorelement. Das pyroelektrische Detektorelement besteht, wie eingangs beschrieben, aus einer pyroelektrischen Schicht mit einem pyroelektrisch sensitiven Material und beidseitig angebrachten Elektrodenschichten. Das pyroelektrisch sensitive Material ist beispielsweise eine Keramik wie Lithiumniobat (LiNbO₃) oder Bleizirkonattitanat. Denkbar ist auch ein ferroelektrisches Polymer wie Polyvinylidenfluorid (PVDF). Als Elektrodenmaterial der Elektrodenschichten kommt beispielsweise Platin oder eine Platinlegierung in Frage. Denkbar ist auch eine Chrom-Nickel-Elektrode oder eine Elektrode aus einem elektrisch leitenden Oxid. Das Detektorelement verfügt beispielsweise über eine rechteckige Grundfläche mit einer Kantenlänge von 25 µm bis 200 µm.

Gemäß einer besonderen Ausgestaltung sind der Schaltungsträger und die Membran derart aneinander angeordnet, dass zwischen der Membran und dem Schaltungsträger mindestens ein vom Schaltungsträger und von der Membran begrenzter schaltungsseitiger Hohlraum vorhanden ist. Der Hohlraum bewirkt eine thermische Entkopplung des Schaltungsträgers und der Membran voneinander.

In einer besonderen Ausgestaltung ist mindestens eine Abdeckung zum Abdecken des Detektorelements vorhanden. Dabei sind der Schaltungsträger, die Membran und die Abdeckung derart zu einem Stapel angeordnet sind, dass die Membran zwischen dem Schaltungsträger und der Abdeckung angeordnet ist. Durch die Abdeckung ist das Detektorelement vor einem schädlichen Umwelteinfluss geschützt. Der Umwelteinfluss ist beispielsweise Staub, Luftfeuchtigkeit oder eine ätzende Chemikalie, die einen Bestandteil des Detektorelements angreifen oder die Funktionsweise des Detektorelements beeinträchtigen würde.

Gemäß einer weiteren Ausgestaltung sind die Membran und die Abdeckung derart aneinander angeordnet, dass zwischen der Membran und der Abdeckung mindestens ein abdeckungsseitiger Hohlraum vorhanden ist. Der abdeckungsseitige Hohlraum dient der thermischen Entkopplung der Membran bzw. des Detektorelements auf der Membran und der Abdeckung voneinander.

Zur Verbesserung der thermischen Entkopplungen sind der schaltungsseitige Hohlraum und/oder der abdeckungsseitige Hohlraum evakuiert oder evakuierbar. Dabei können die beiden Hohlräume unabhängig voneinander evakuierbar sein. Vorzugsweise stehen der schaltungsseitige Hohlraum und der abdeckungsseitige Hohlraum durch eine Öffnung in der Membran hindurch miteinander in Verbindung. Die Öffnung ist beispielsweise ein Schlitz in der Membran. Durch Evakuieren eines der Hohlräume wird der andere Hohlraum automatisch mit evakuiert.

Unabhängig vom Effekt, der zur Detektion der Wärmestrahlung ausgenutzt wird, ist eine Absorption der Wärmestrahlung durch jeweils ein den entsprechenden Effekt auslösendes, thermisch sensitives Material des Detektorelements notwendig. Die Absorption erfolgt direkt durch das thermisch sensitive Material. Denkbar ist aber auch, dass die Wärmestrahlung durch eine Elektrode bzw. Elektrodenschicht des Detektorelements absorbiert wird. Zudem ist es auch.möglich, dass die Wärmestrahlung durch einen Absorptionsgegenstand in unmittelbarer Nähe des Detektorelements absorbiert und eine dadurch aufgenommene Wärmemenge durch Konvektion oder Wärmeleitung an das thermisch sensitive Material abgegeben wird. Der Absorptionsgegenstand fungiert als Energietransmitter. Beispielsweise ist der Absorptionsgegenstand als Beschichtung direkt auf das Detektorelement aufgebracht.

Die Vorrichtung zur Detektion der Wärmestrahlung ist vorzugsweise derart ausgestaltet, dass die Wärmestrahlung direkt auf das Detektorelement gelangt. Dazu weisen in einer besonderen Ausgestaltung die Membran, der Schaltungsträger und/oder die Abdeckung mindestens ein Bestrahlungsfenster mit einer bestimmten Transmission für die Wärmestrahlung zum Bestrahlen des Detektorelements mit der Wärmestrahlung auf. Das Bestrahlungsfenster ist in der Abdeckung, im Detektorträger und/oder im Schaltungsträger integriert. Das Detektorelement und das Bestrahlungsfenster sind derart aneinander angeordnet, dass die Bestrahlung des Detektorelements von einer dem Detektorträger abgewandten Vorderseite des Detektorelements (Vorderseitenbestrahlung) und/oder von einer dem Detektorträger zugewandten Rückseite des Detektorelements (Rückseitenbestrahlung) erfolgt. Das Bestrahlungsfenster weist in Richtung des Detektionselements eine bestimmte Transmission auf. Die Transmission ist möglichst hoch und beträgt beispielsweise über 50% und insbesondere über 70% bis nahe 95%.

Als Material des Schaltungsträgers bzw. der Abdeckung kommen beliebige Materialien in Frage. Halbleitende Materialien, beispielsweise elementares Germanium oder verschiedene halbleitende Verbindungen eignen sich wegen der Möglichkeit der Integration von elektrischen Schaltungen oder Bauteilen besonders. Gemäß einer besonderen Ausgestaltung weisen der Schaltungsträger und/oder die Abdeckung Silizium auf. Es wird jeweils ein Silizium-Substrat als Abdeckung und/oder als Schaltungsträger verwendet. Durch die CMOS-Technik können beliebige Strukturen und Funktionalitäten in die Substrate integriert werden. Da Silizium bezüglich der Wärmestrahlung einen niedrigen Absorptionskoeffizienten aufweist, kann zudem das Bestrahlungsfenster sehr leicht in einem Silizium-Substrat integriert werden: Das Silizium-Substrat selbst bildet das Bestrahlungsfenster. Durch eine geeignete Anordnung der entsprechenden Funktionalitäten im Silizium-Substrat wird dafür gesorgt, dass die Wärmestrahlung ungehindert, also ohne Abschattung, auf das Detektorelement gelangt.

Die Transmission hängt nicht nur vom Absorptionskoeffizienten des Materials ab, aus dem das Bestrahlungsfenster besteht. Entscheidend ist auch eine Dicke des Bestrahlungsfensters. Vorteilhaft wird das Bestrahlungsfenster von einem ausgedünnten Bereich des Detektorträgers oder des Schaltungsträgers gebildet. In einer besonderen Ausgestaltung ist das Detektorelement gegenüber einer Abdeckungsausnehmung der Abdeckung angeordnet. Die Abdeckungsausnehmung ist ein Bereich der Abdeckung mit relativ niedriger Dicke. In diesem Bereich ist die Abdeckung ausgedünnt, beispielsweise durch Materialabtrag. Die Abdeckungsausnehmung bildet das Bestrahlungsfenster, das in der Abdeckung integriert ist und durch das die Wärmestrahlung auf das Detektorelement gelangt. Das Detektorelement ist vorzugsweise von der Abdeckungsausnehmung beabstandet. Die Abdeckungsausnehmung ist Bestandteil des abdeckungsseitigen Hohlraums zwischen der Membran und der Abdeckung.

In einer besonderen Ausgestaltung sind die Membran und der Schaltungsträger und/oder die Membran und die Abdeckung und/oder die Durchkontaktierung und der Schaltungsträger und/oder die Durchkontaktierung und die Abdeckung durch einen Stoffschluss und insbesondere durch einen hermetischen Stoffschluss fest miteinander verbunden. Zum festen Verbinden wird ein Stoffschluss hergestellt. Ein festes Verbinden der Membran und des Schaltungsträgers wird durch Herstellen eines Stoffschlusses zwischen der elektrischen Durchkontaktierung der Membran und dem Schaltungsträger hergestellt. Ein festes Verbinden der Membran und der Abdeckung wird durch Herstellen eines Stoffschlusses zwischen der Membran und der Abdeckung hergestellt. Die Stoffschlüsse zwischen den verschiedenen Bestandteilen der Vorrichtung können nacheinander oder gleichzeitig hergestellt werden. Die Stoffschlüsse sind derart ausgestaltet, dass evakuierbaren (abdeckungsseitige oder schaltungsseitige) Hohlräume gebildet werden. Komponenten der Vorrichtung, die sich in den Hohlräumen befinden, beispielsweise das Detektorelement im abdeckungsseitigen Hohlraum, sind durch den hermetischen Stoffschluss von einer Umgebung abgeschirmt. Es findet kein Stoffaustausch mit der Umgebung statt. Somit kann die Vorrichtung auch in einer aggressiven Umgebung eingesetzt werden.

Der jeweilige Stoffschluss kann von einem beliebigen Stoff, beispielsweise einem Klebstoff gebildet werden. Besonders vorteilhaft ist es, mit dem Stoffschluss gleichzeitig eine elektrisch leitende Verbindung zwischen den Elektrodenschichten des Detektorelements und der Ausleseschaltung herzustellen. Dazu weist in einer besonderen Ausgestaltung der Stoffschluss einen elektrisch leitfähigen Stoff auf. Dies betrifft insbesondere den Stoffschluss zwischen der in der Membran integrierten elektrischen Durchkontaktierung und dem Schaltungsträger bzw. dem Ausleseschaltkreis des Schaltungsträgers. Aber auch ein Stoffschluss mit einem elektrisch leitfähigen Stoff kann zwischen der Abdeckung und der Membran bzw. dem Detektorelement auf der Membran vorteilhaft sein, wenn in der Abdeckung Verdrahtungsbestandteile für das Detektorelement integriert sind.

Prädestiniert für die Herstellung des Stoffschlusses ist die so genannte "Flip-chip"-Technik. Darunter wird ein Montageverfahren aus dem Bereich der Aufbau und Verbindungstechnik (AVT) verstanden, die sich vor allen Dingen in der Mikroelektronik zur Kontaktierung von Halbleiter-Mikrochips oder von integrierten Schaltungen in ungehäuster Form bewährt hat. Bei der Flip-Chip-Technik wird ein Chip direkt, ohne weitere Anschlussdrähte, mit einer aktiven Kontaktierungsseite nach unten zum Substrat (Schaltungsträger) hin montiert. Eine Montage erfolgt über sogenannte "Bumps" aus elektrisch leitendem Material. Dies führt zu sehr kurzen Leiterlängen. Dies wird bei der vorliegenden Erfindung ausgenutzt: Es resultiert ein kompakter Aufbau. Durch die sehr kurzen Leiterlängen werden zudem unerwünschte, das auszulesende elektrische Signal störende Streuinduktivitäten und -kapazitäten auf ein Mindestmaß reduziert. Dieser Einfluss wirkt sich insbesondere vorteilhaft bei einer relativ kleinen Anzahl von zu kontaktierenden Detektorelementen aus. Mit Hilfe der Flip-Chip-Technik kann zudem eine Vielzahl von elektrischen Verbindungen gleichzeitig hergestellt werden, was einen enormen Zeit- und damit Kostenvorteil mit sich bringt.

Zur Realisierung der "Flip-Chip"-Technik und damit zum Herstellen des Stoffschlusses können verschiedene Techniken eingesetzt werden. In einer besonderen Ausgestaltung wird zum Herstellen des Stoffschlusses ein aus der Gruppe Kleben, Löten und/oder Bonden ausgewähltes Verfahren durchgeführt. Dabei sind adhäsives Bonden oder eutektisches Bonden denkbar. Zum Löten werden Bumps aus einem Lot (Lotkugeln) auf einem oder auf beide miteinander zu verbindenden Träger bzw. Bestandteile der Vorrichtung aufgebracht. Die genannten Verfahren sind an sich gegenüber dem Kleben zu bevorzugen, da es bei einem Klebstoff zu Ausgasungen von organischen Bestandteilen (Lösungsmittel, Klebstoffkomponente,...) kommen kann. Dies spielt insbesondere im Hinblick auf die Evakuierung der Hohlräume eine Rolle. Nichtsdestotrotz kann es aber notwendig oder vorteilhaft sein, auf das Kleben zurückzugreifen.

Beim Kleben kann auf verschiedene Varianten zurückgegriffen werden: Das Kleben kann mit einem elektrisch nicht leitfähigem Klebstoff erfolgen. Dazu sind auf Kontaktflächen des entsprechenden Trägers Bumps aufgebracht. Die Bumps bestehen beispielsweise aus Aluminium oder Gold. Danach wird auf den Träger eine Klebstoffschicht des Klebstoffs aufgetragen und das entsprechende Gegenstück auf der Klebstoffschicht angeordnet. Beim Trocknen schrumpft der Klebestoff und es bilden sich die elektrischen Kontakte.

Ebenso kann zum Kleben ein isotrop leitfähiger Klebstoff verwendet werden. Auf die Kontaktflächen eines Trägers wird leitfähiger Klebstoff aufgebracht. Danach wird das Gegenstück mit seinen Kontaktflächen auf die Klebepunkte gesetzt. Der Klebstoff kann thermisch oder mittels UV-Strahlung ausgehärtet werden und stellt so den elektrisch leitfähigen Stoffschluss her.

Alternativ dazu wird ein anisotrop leitfähiger Klebstoff verwendet. Anisotrop leitfähiger Klebstoff ist ein Verbundmaterial aus elektrisch nicht leitfähigem Klebstoff und darin mit geringem Füllgrad enthaltenen, elektrisch leitfähigen Partikeln. Der anisotrop leitfähige Klebstoff wird auf den Kontaktflächen des Trägers (Schaltungsträger, Membran) aufgetragen. Durch den geringen Füllgrad stehen die elektrisch leitfähigen Partikel nach dem Auftragen nicht in Verbindung miteinander. Es bildet sich keine elektrisch leitfähige Verbindung. Beim Aufsetzen des Gegenstücks wird der elektrisch nicht leitfähige Klebstoff verdrängt, bis die Partikel zwischen den Kontaktflächen des Trägers und den Kontaktflächen des Gegenstücks eingeklemmt werden und eine elektrisch leitfähige Verbindung zwischen den Kontaktflächen entsteht.

Zum Bereitstellen der Membran werden insbesondere folgende weiteren Verfahrensschritte durchgeführt: d) Bereitstellen eines Opferträgers mit Opfermaterial, c) Anordnen einer Membran auf einem Oberflächenabschnitt des Opferträgers und Zusammenbringen der Membran und eines Membranträgers zum Tragen der Membran und e) Entfernen von Opfermaterial, so dass die Membran zumindest teilweise freigelegt wird. Der Opferträger ist vorzugsweise aus Silizium. Der Membranträger dient beispielsweise zwischenzeitlich als Träger der Membran. Der Memnbranträger kann aber auch als spätere Abdeckung des Detektorelemets fungieren. Das Anordnen der Membran auf dem Opferträger und das Zusammenbringen der Membran und des Membranträgers kann gleichzeitig oder nacheinander erfolgen. Das Entfernen des Materials bedeutet hier beispielsweise ein rückseitiges Wegätzen von Silizium bis hin zur Membran. Übrig bleibt die Membran auf dem Membranträger mit der Durchkontaktierung, die anschließend mit dem Schaltungsträger verbunden wird.

Das Erzeugen der Durchkontaktierung kann in beliebigen Verfahrensstufen erfolgen. Gemäß einer besonderen Ausgestaltung werden vor dem Anordnen der Membran auf dem Opferträger oder nach dem Anordnen der Membran auf dem Opferträger folgende weiteren Verfahrensschritte durchgeführt: f) Erzeugen einer Bohrung in der Membran und g) Befüllen der Bohrung mit elektrisch leitfähigem Material, so dass die elektrische Durchkontaktierung entsteht.

Gemäß einer besonderen Ausgestaltung des Verfahrens werden während und/oder nach dem festen Verbinden der abdeckungsseitige Hohlraum und/oder der schaltungsseitige Hohlraum evakuiert. Beispielsweise erfolgt das Herstellen des Stoffschlusses zwischen den Bestandteilen des Stapels im Vakuum. Mit der Ausbildung des Stoffschlusses wird der jeweilige Hohlraum evakuiert. Denkbar ist auch, dass die Hohlräume zunächst hergestellt und im Nachhinein evakuiert werden. Auch hier gilt: Die Hohlräume können nacheinander oder gleichzeitig evakuiert werden. Zum gleichzeitigen Evakuieren können die Hohlräume isobar miteinander verbunden sein. Dies bedeutet, dass der Druck in den beiden Stapelhohlräumen gleich ist und beispielsweise durch eine Öffnung in der Membran miteinander in Verbindung stehen.

Die Vorrichtung kann ein einziges Detektorelement aufweisen. Im Hinblick auf eine Anwendung der Vorrichtung als Präsenzmelder oder insbesondere als Wärmebildkamera ist es aber vorteilhaft bzw. notwendig, dass mehrere Detektorelemente vorhanden sind. In einer besonderen Ausgestaltung ist daher mindestens ein Detektorarray mit mehreren Detektorelementen vorhanden. Ein Detektorelement ist dabei ein Pixel des Detektorarrays. Das Detektorarray zeichnet sich beispielsweise durch eine spalten- und/oder zeilenförmige Anordnung der Detektorelemente aus. Bei einer zeilenförmigen oder spaltenförmigen Anordnung sind die Detektorelemente eindimensional in einer Richtung verteilt. Bei einer spalten- und zeilenförmigen Anordnung liegt eine zweidimensionale Verteilung vor. Das Detektorarray besteht beispielsweise aus 240 x 320 einzelnen Elementen. Dies entspricht dem relativ niedrigen Auflösungsstandard QVGA. Denkbar ist übrigens auch eine willkürliche, flächige Verteilung der Detektorelemente. Für jedes der Detektorelemente kann ein eigenes Bestrahlungsfenster vorgesehen sein. Vorteilhaft ist aber, dass die Vorrichtung ein einziges Bestrahlungsfenster für mehrere oder für alle Detektorelemente aufweist. Damit kann die Herstellung der Vorrichtung vereinfacht werden.

Gemäß einer weiteren Ausgestaltung weist die Vorrichtung eine Umhüllung auf. Durch das feste Verbinden der Membran und des Schaltungsträgers und durch das feste Verbinden der Membran und der Abdeckung entsteht ein Stapel, an den eine Umhüllung abgeordnet wird. Die Umhüllung schützt den Stapel mit seinen Bestandteilen vor schädlichen Umwelteinflüssen, beispielsweise Feuchtigkeit, oder vor mechanischer Zerstörung. Zu beachten ist dabei lediglich, dass die Bestrahlung des Detektorelements durch die Umhüllung nicht beeinträchtigt wird. Dazu wird ein Bestrahlungsfenster mit hoher Transmission für die Wärmestrahlung in die Umhüllung integriert.

Die Umhüllung kann dabei ein Gehäuse aus einem beliebigen Material sein. Vorzugsweise ist die Umhüllung eine Vergussmasse. Dazu wird zum Anordnen der Umhüllung ein aus der Gruppe Spritzgussverfahren oder Moldverfahren ausgewähltes Verfahren durchgeführt. Diese Verfahren sind aus Kostengründen besonders vorteilhalt. Dabei wird un- oder teilvernetzter Kunststoff auf den Stapel aufgebracht. Nach dem Auftragen wird der Kunststoff thermisch induziert oder durch Bestrahlung mit UV-Licht ausgehärtet. Zur Integration des Bestrahlungsfensters wird beispielsweise eine Maske benutzt, die nach dem Anordnen des Kunststoffs oder nach dem Aushärten des Kunststoffs entfernt wird. Dies gelingt beispielsweise durch Transfermolden mit einem gefederten Insert. Denkbar ist auch die Verwendung eines Bestrahlungsfensters aus einem Material mit hoher Transmission für die Wärmestrahlung, die nach dem Auftragen und Aushärten des Kunststoffs in der Umhüllung verbleibt.

Mit dem beschriebenen Verfahren kann eine einzige Vorrichtung zur Detektion von Wärmestrahlung hergestellt werden. Vorteilhaft werden aber mehrere Vorrichtungen gleichzeitig, also parallel hergestellt. Die Herstellung erfolgt im Nutzen. In einer besonderen Ausgestaltung wird daher eine Vielzahl von Vorrichtungen zur Detektion von Wärmestrahlung auf Wafer-Ebene hergestellt. Nach dem Herstellen wird ein Vereinzeln der Vorrichtungen bzw. der Stapel der Vorrichtungen durchgeführt. Es werden der Schaltungsträger und eventuell die Abdeckung als Wafer, insbesondere als Silizium-Wafer mit jeweils einer Vielzahl von entsprechenden Bestandteilen und Funktionalitäten verwendet und wie oben beschriebenen zusammengebracht. Nach dem Zusammenbringen und vorteilhaft vor dem Anordnen der Umhüllungen werden die Stapel voneinander getrennt. Das Trennen bzw. Vereinzeln geschieht beispielsweise durch Sägen, durch Erodieren oder durch ähnliche Verfahren. Nach dem Vereinzeln wird an die Stapel der Vorrichtungen jeweils eine Umhüllung angebracht.

Gemäß einem weiteren Aspekt der Erfindung wird die Vorrichtung als Bewegungsmelder, als Präsenzmelder und/oder als Wärmebildkamera verwendet. Für einen Bewegungsmelder kann eine Vorrichtung mit einem einzigen Detektorelement ausreichend sein. Für einen Präsenzmelder kann die Vorrichtung mit mehreren Detektorelementen ausgestattet sein. Für die Wärmebildkamera ist die Vorrichtung mit einer Vielzahl von Detektorelementen, beispielsweise 240 X 320 Detektorelemente (QVGA-Standard) und mehr ausgestattet. Dies ist durch die einfache und Platz sparende Verdrahtung der Detektorelemente möglich.

Zusammenfassend sind folgende Vorteile der Erfindung hervorzuheben:
- Die Vorrichtung zur Detektion von Wärmestrahlung ist kompakt.
- Durch die Sandwichbauweise kann eine Vielzahl von Detektorelementen Platz sparend kontaktiert werden.
- Die elektrischen Leitungen zwischen den Elektroden eines Detektorelements und dem zugeordneten Ausleseschaltkreis bzw. Ausleseelement sind kurz. Induktivitäten und Kapazitäten, die zu Störsignalen führen und damit die Detektvität des Detektorelements beeinflussen könnten, sind im Vergleich zu Bonddrähten deutlich reduziert.
- Durch die Art der Kontaktierung ist ein hohes Maß an Parallelisierung bei der Herstellung möglich.
- Durch den hermetischen Stoffschluss sind die zur Verbesserung der Empfindlichkeit der Vorrichtung und zum Schutz des Detektorelements beitragenden evakuierbaren Hohlräume einfach zugänglich.

Anhand mehrerer Ausführungsbeispiele und der dazugehörigen Figuren wird im Folgenden eine Vorrichtung zur Detektion von Wärmestrahlung vorgestellt. Die Figuren sind schematisch und stellen keine maßstabsgetreuen Abbildungen dar.

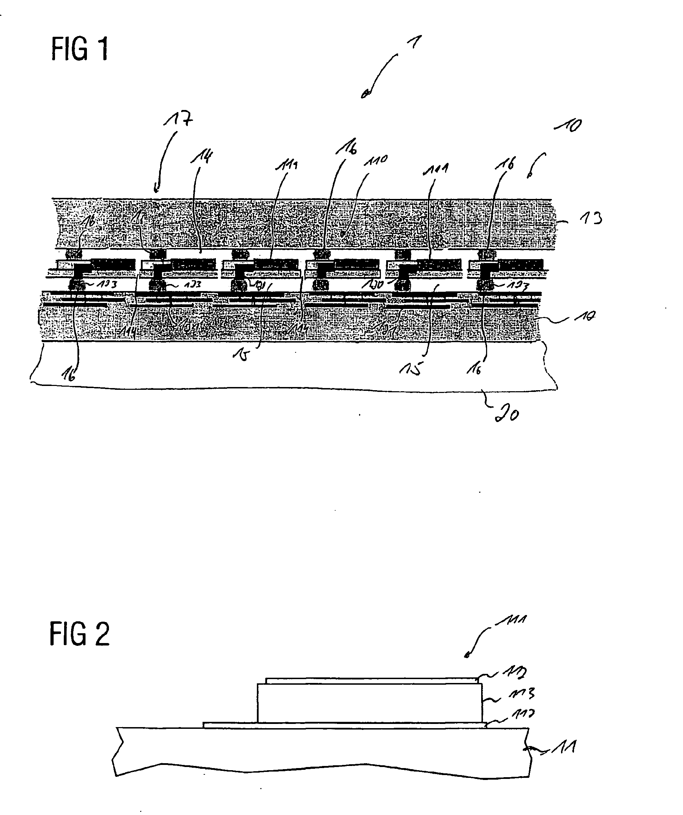

Figur 1 zeigt eine Vorrichtung zur Detektion von Wärmestrahlung in einem seitlichen Querschnitt.

Figur 2 zeigt ein Detektorelement auf einem Detektorträger in einem seitlichen Querschnitt.

Die Vorrichtung 1 zur Detektion von Wärmestrahlung weist einen Stapel 10 mit einer Membran 11 mit einem Detektorarray 110 von thermischen Detektorelement 111 zur Umwandlung der Wärmestrahlung in elektrisches Signale, einem Schaltungsträger 12 mit einer Ausleseschaltung 121 zum Auslesen der elektrischen Signale, und mindestens einer Abdeckung 13 zum Abdecken der Detektorelemente, wobei die Membran und die Abdeckung derart aneinander angeordnet sind, dass zwischen den Detektorelementen des Detektorträgers und der Abdeckung ein, vom Detektorträger und von der Abdeckung begrenzter, abdeckungsseitiger Hohlraum 14 des Stapels vorhanden ist, der Schaltungsträger und die derart aneinander angeordnet sind, dass zwischen dem Detektorträger und dem Schaltungsträger mindestens ein, vom Schaltungsträger und vom Detektorträger begrenzter, schaltungsseitiger Hohlraum 15 des Stapels vorhanden ist und die Hohlräume evakuiert sind. Die Hohlräume stehen durch Schlitze durch die Membran hindurch miteinander in Verbindung.

Die Detektorelemente sind pyroelektrische Detektorelemente in Dünnschichtbauweise mit zwei Elektrodenschichten 112 und einer zwischen den Elektrodenschichten angeordneten pyroelektrischen Schicht 113 (Figur 3). Die pyroelektrische Schicht ist eine ca. 1 µm dicke Schicht aus PZT als pyroelektrisch sensitives Material. Die Elektrodenschichten sind aus Platin und einer Chrom-Nickel-Legierung mit Schichtdicken von etwa 20 nm.

Die Membran ist eine Si₃N₄/SiO₂/Si₃N₄ - Dreifach-Schicht. Für die Detektorelemente ist im Schaltungsträger eine Auslesschaltung integriert.

Der Schaltungsträger und die Abdeckung sind jeweils Siliziumsubstrate. Die Detektorelemente sind innerhalb des ersten Stapelhohlraums gegenüber einer nicht dargestellten Abdeckungsausnehmung der Abdeckung angeordnet. Im Bereich der Ausnehmung ist ein gemeinsames Bestrahlungsfenster 17 angeordnet, durch das die Wärmestrahlung auf Detektorelemente gelangt. Die Bestrahlung erfolgt von der Vorderseite aus.

Sowohl die Membran und die Abdeckung als auch der Detektorträger und der Schaltungsträger sind durch einen hermetischen Stoffschluss 16 fest miteinander verbunden. Gemäß einer ersten Ausführungsform besteht der Stoffschluss aus einem Lot. Die Träger (Siliziumsubstrate) sind miteinander verlötet. Alternativ dazu wird der Stoffschluss durch Bonden hergestellt.

Durch den Stoffschluss zwischen dem Schaltungsträger und der Membran ist für eine elektrische Verdrahtung 123 der Detektorelemente gesorgt. Über die Verdrahtung bzw. über die Ausleseschaltung werden die elektrischen Signale der Detektorelemente ausgelesen. Der Stoffschluss zwischen der Abdeckung und der Membran ist ebenfall aus elektrisch leitfähigem Material. Allerdings ist hier jeweils eine elektrische Isolierung 161 vorgesehen.

Zum Bereitstellen der Membran wird wie folgt vorgegangen: Bereitstellen eines Opferträgers aus Silizium, Anordnen einer Membran mit Durchkontaktierungen auf einem Oberflächenabschnitt des Opferträgers und Entfernen von Opfermaterial, so dass die Membran zumindest teilweise freigelegt wird. Zum Entfernen des Siliziums wird ein rückseitiges Wegätzen von Silizium bis hin zur Membran durchgeführt. Übrig bleibt die Membran mit der Durchkontaktierung, die anschließend mit dem Schaltungsträger verbunden wird.

Das Erzeugen der Durchkontaktierung kann in beliebigen Verfahrensstufen erfolgen. Gemäß einer besonderen Ausgestaltung werden vor dem Anordnen der Membran auf dem Opferträger oder nach dem Anordnen der Membran auf dem Opferträger folgende weiteren Verfahrensschritte durchgeführt: f) Erzeugen einer Bohrung in der Membran und g) Befüllen der Bohrung mit elektrisch leitfähigem Material, so dass die elektrische Durchkontaktierung entsteht.

Während des Herstellens der Stoffschlüsse wird Vakuum angelegt, so dass sich ein Unterdruck in den entstehenden Stapelhohlräumen ausbildet. Die Stapelhohlräume werden bei deren Bildung evakuiert. Alternativ dazu werden die Stapelhohlräume nach dem Herstellen der Stoffschlüsse evakuiert.

Nach dem Herstellen des Stapels wird der Stapel mit einer Umhüllung 20 versehen. Dazu wird ein unvernetzter Kunststoff in einem Spritzgussverfahren auf den Stapel aufgetragen und anschließend vernetzt. Alternativ dazu wird ein Moldverfahren durchgeführt. Dabei wird dafür gesorgt, dass das Bestrahlungsfenster der Abdeckung frei bleibt, also nicht bedeckt wird.

Zum Herstellen der Vorrichtung werden die Membran mit dem Detektorarray, der Schaltungsträger mit der Ausleseschaltung und die Abdeckung bereitgestellt und wie oben beschrieben fest miteinander verbunden. Das Herstellen erfolgt dabei auf Wafer-Ebene. Dazu werden Silizium-Wafer mit einer Vielzahl von entsprechenden Funktionalitäten (Ausleseschaltungen eventuell Abdeckungsausnehmungen) versehen. Es werden auf Wafer-Ebene der Schaltungsträger mit der Membran und die Abdeckung bereitgestellt. Diese funktionalisierten Silizum-Wafer werden wie oben beschrieben fest miteinander verbunden. Es wird ein Wafer-Stapel mit einer Vielzahl von Einzel-Stapeln hergestellt. Nach dem Verbinden werden die Einzel-Stapel durch Zersägen des Wafer-Stapels vereinzelt und mit jeweils einer Umhüllung versehen.

Verwendung findet die Vorrichtung in einem Bewegungsmelder oder Präsenzmelder. Für die Anwendung in einer Wärmebildkamera ist eine Vielzahl Stapeln bzw. von Vorrichtungen mit jeweils einem Stapel vorhanden.

## Patentansprüche

1. Vorrichtung (1) zur Detektion von Wärmestrahlung, aufweisend
- mindestens eine Membran (11), auf der mindestens ein thermisches Detektorelement (111) zur Umwandlung der Wärmestrahlung in ein elektrisches Signal angeordnet ist, und
- mindestens einen Schaltungsträger (12) zum Tragen der Membran und mit mindestens einer Ausleseschaltung (121) zum Auslesen des elektrischen Signals,
- mindestens eine Abdeckung (13) zum Abdecken des Detektorelements, das auf der Membran der Abdeckung zugewandt angeordnet ist, wobei der Schaltungsträger, die Membran und die Abdeckung derart zu einem Stapel angeordnet sind, dass die Membran zwischen dem Schaltungsträger und der Abdeckung angeordnet ist, wobei der Stapel eine Sandwichbauweise hat, wobei der Schaltungsträger und die Membran derart aneinander angeordnet sind, dass zwischen der Membran und dem Schaltungsträger mindestens ein vom Schaltungsträger und von der Membran begrenzter evakuierter schaltungsseitiger Hohlraum (15) vorhanden ist, wobei die Membran und die Abdeckung derart aneinander angeordnet sind, dass zwischen der Membran und der Abdeckung mindestens ein abdeckungsseitiger Hohlraum (14) vorhanden ist,
- das Detektorelement und die Ausleseschaltung über eine elektrische Durchkontaktierung (120) durch die Membran hindurch und einen einen elektrisch leitfähigen Stoff aufweisenden hermetischen Stoffschluss (16) zwischen der elektrischen Durchkontaktierung der Membran und dem Schaltungsträger elektrisch miteinander verbunden sind, wobei die Durchkontaktierung und der Schaltungsträger durch den Stoffschluss fest miteinander verbunden sind, so dass für eine elektrische Verdrahtung (123) des Detektorelements mit der Ausleseschaltung gesorgt ist, und wobei der hermetische Stoffschluss (16) derart ausgestaltet ist, dass der evakuierte schaltungsseitige Hohlraum (15) gebildet wird und Komponenten der Vorrichtung, die sich im Hohlraum befinden, durch den hermetischen Stoffschluss (16) von einer Umgebung abgeschirmt werden.

2. Vorrichtung nach Anspruch 1, wobei der abdeckungsseitige Hohlraum evakuiert ist.

3. Vorrichtung nach Anspruch 1 oder 2, wobei der schaltungsseitige Hohlraum und der abdeckungsseitige Hohlraum durch eine Öffnung (114) in der Membran hindurch miteinander in Verbindung stehen.

4. Vorrichtung nach einem der Anspruche 1 bis 3, wobei die Membran, der Schaltungsträger und/oder die Abdeckung mindestens ein Bestrahlungsfenster (17) mit einer bestimmten Transmission für die Wärmestrahlung zum Bestrahlen des Detektorelements mit der Wärmestrahlung aufweisen.

5. Vorrichtung nach einem der Ansprüche 1 bis 4, wobei der Schaltungsträger und/oder die Abdeckung Silizium aufweisen.

6. Vorrichtung nach einem der Ansprüche 1 bis 5, wobei das Detektorelement gegenüber einer Abdeckungsausnehmung der Abdeckung angeordnet ist.

7. Vorrichtung nach einem der Ansprüche 1 bis 6, wobei die Membran und der Schaltungsträger und/oder die Membran und die Abdeckung und/oder die Durchkontaktierung und die Abdeckung durch den Stoffschluss (16) fest miteinander verbunden sind.

8. Vorrichtung nach einem der Anspruche 1 bis 7, wobei mindestens ein Detektorarray mit mehreren Detektorelementen vorhanden ist.

9. Verfahren zum Herstellen einer Vorrichtung nach einem der vorangegangenen Ansprüche mit folgenden Verfahrensschritten:
- Bereitstellen einer Membran (11) mit einem Detektorelement (111) und mindestens einer elektrischen Durchkontaktierung (120) und Bereitstellen eines Schaltungsträgers (12) mit einer Ausleseschaltung (121) sowie Bereitstellen einer Abdeckung (13),
- Zusammenbringen der Membran und des Schaltungsträgers derart, dass das Detektorelement und die Ausleseschaltung über eine elektrische Durchkontaktierung durch die Membran hindurch elektrisch miteinander verbunden sind und ein schaltungsseitiger Hohlraum (15) vorhanden ist,
- Zusammenbringen der Membran und der Abdeckung derart, dass das Detektorelement der Abdeckung zugewandt ist und von der Abdeckung abgedeckt ist, wobei durch das Zusammenbringen der Membran und des Schaltungsträgers und durch das Zusammenbringen der Membran und der Abdeckung ein Stapel (10) entsteht, wobei der Stapel eine Sandwichbauweise hat,
- festes Verbinden der Membran und der Abdeckung durch Herstellen eines Stoffschlusses zwischen der Membran und der Abdeckung, so dass ein abdeckungsseitiger Hohlraum (14) vorhanden ist,
- Bereitstellen eines Opferträgers mit Opfermaterial,
- Anordnen der Membran auf einem Oberflächenabschnitt des Opferträgers und Zusammenbringen der Membran und des Schaltungsträgers
- Entfernen von Opfermaterial, so dass die Membran zumindest teilweise freigelegt wird,
- Erzeugen einer Bohrung in der Membran
- Befüllen der Bohrung mit elektrisch leitfähigem Material, so dass die elektrische Durchkontaktierung entsteht, und
- festes Verbinden der Membran und des Schaltungsträgers durch Herstellen eines hermetischen Stoffschlusses (16) zwischen der elektrischen Durchkontaktierung der Membran und dem Schaltungsträger, wobei zum Herstellen des Stoffschlusses ein aus der Gruppe Kleben, Löten und/oder Bonden ausgewähltes Verfahren durchgeführt wird, und wobei mit der Ausbildung des hermetischen Stoffschlusses (16) der schaltungsseitige Hohlraum (15) gebildet wird, so dass Komponenten der Vorrichtung, die sich im Hohlraum befinden, durch den hermetischen Stoffschluss (16) von einer Umgebung abgeschirmt werden.

10. Verfahren nach Anspruch 9, wobei während dem festen Verbinden der abdeckungsseitige Hohlraum evakuiert wird.

11. Verfahren nach einem der Ansprüche 9 bis 10, wobei eine Vielzahl von Vorrichtungen zur Detektion von Wärmestrahlung auf Wafer-Ebene hergestellt wird und nach dem Herstellen ein Vereinzeln der Vorrichtungen durchgeführt wird.

## Claims

1. Device (1) for detecting thermal radiation, comprising
- at least one membrane (11), on which at least one thermal detector element (111) for the conversion of the thermal radiation into an electric signal is arranged, and
- at least one circuit support (12) for supporting the membrane and with at least one read-out circuit (121) to read out the electric signal,
- at least one cover (13) to shield the detector element, which is arranged on the membrane and facing towards the cover, wherein the circuit support, the membrane and the cover are arranged in a stack such that the membrane is arranged between the circuit support and the cover, wherein the stack has a sandwich structure, wherein the circuit support and the membrane are arranged next to each other such that between the membrane and the circuit support at least one evacuated cavity (15) is present facing towards the circuit and bounded by the circuit support and the membrane, wherein the membrane and the cover are arranged next to each other such that at least one cavity (14) facing towards the cover is present between the membrane and the cover,
- the detector element and the read-out circuit are coupled electrically conductive with each other via an electric through contact (120) through the membrane and a hermetically-sealed permanent material bond (16) comprising an electric conductive material and arranged between the electric through contact of the membrane and the circuit support, wherein the through contact and the circuit support are fixedly attached to each other by the permanent material bond, so that an electric wiring (123) is provided for the detector element with the read-out circuit, and wherein the hermetically-sealed permanent material bond (16) is formed such that the evacuated cavity (15) facing towards the circuit is formed and components of the device arranged inside the cavity are shielded by the hermetically-sealed permanent material bond (16) from the surroundings.

2. Device according to claim 1, wherein the cavity facing towards the cover is evacuated.

3. Device according to claim 1 or 2, wherein the cavity facing towards the circuit and the cavity facing towards the cover communicate through an opening (114) in the membrane.

4. Device according to anyone of claims 1 to 3, wherein the membrane, the circuit support and/or the cover comprise at least one irradiation window (17) with a determined transmission for the thermal radiation for irradiating the detector element with the thermal radiation.

5. Device according to anyone of claims 1 to 4, wherein the circuit support and/or the cover comprise silicon.

6. Device according to anyone of claims 1 to 5, wherein the detector element is arranged opposite to a cover recess of the cover.

7. Device according to anyone of claims 1 to 6, wherein the membrane and the circuit support and/or the membrane and the cover and/or the through contact and the cover are fixedly attached to each other by the permanent material bond (16).

8. Device according to anyone of claims 1 to 7, wherein at least one detector array with multiple detector elements is present.

9. Method for making a device according to anyone of the preceding claims with following steps:
- Providing a membrane (11) with a detector element (111) and at least one electric through contact (120) and providing a circuit support (12) with a read-out circuit (121) as well as providing a cover (13),
- Bringing together the membrane and the circuit support such that the detector element and the read-out circuit are coupled electrically conductive with each other via an electric through contact through the membrane and a cavity (15) facing towards the circuit is present,
- bringing together the membrane and the cover such that the detector element is facing towards the cover and is shielded by the cover, wherein a stack is formed by the bringing together of the membrane and the circuit support and by the bringing together of the membrane and the cover, wherein the stack has a sandwich structure,
- fixedly attaching the membrane and the cover by making a permanent material bond between the membrane and the cover such that a cavity (14) facing towards the cover is present,
- providing a sacrifice support with sacrifice material,
- arranging the membrane on a surface section of the sacrifice support and bringing together the membrane and the circuit support,
- removing of sacrifice material such that the membrane is at least partially exposed,
- generating a bore in the membrane,
- filling the bore with electric conductive material so that the electric through contact is formed, and
- fixedly attaching the membrane and the circuit support by making a hermetically-sealed permanent material bond (16) between the electric through contact of the membrane and the circuit support, wherein a method chosen from the group of gluing, brazing and/or bonding is carried out for making the material bond, and wherein the cavity (15) facing towards the circuit support is formed by the formation of the hermetically-sealed permanent material bond (16) so that components of the device arranged inside the cavity are shielded by the hermetically-sealed permanent material bond (16) from the surroundings.

10. Method according to claim 9, wherein the cavity facing towards the cover is evacuated during the fixedly attaching.

11. Method according to anyone of claims 9 to 10, wherein a multitude of devices for detecting thermal radiation is made on wafer-level and after said making a separation of the devices is carried out.

## Revendications

1. Dispositif (1) de détection de rayonnement thermique, comprenant :
- au moins une membrane (11), sur laquelle est disposé au moins un élément détecteur thermique (111) pour transformer le rayonnement thermique en un signal électrique, et
- au moins un porte-circuit (12) destiné à porter la membrane et doté d'au moins un circuit de lecture (121) pour lire le signal électrique,
- au moins un élément de recouvrement (13) pour recouvrir l'élément détecteur, qui est disposé sur la membrane en étant tourné vers l'élément de recouvrement, sachant que le porte-circuit, la membrane et l'élément de recouvrement sont disposés en une pile de telle sorte que la membrane est disposée entre le porte-circuit et l'élément de recouvrement, la pile possédant une structure sandwich, le porte-circuit et la membrane état disposés l'un par rapport à l'autre de telle sorte qu'au moins une cavité mise au vide (15), délimitée par le porte-circuit et par la membrane, est présente côté circuit entre la membrane et le porte-circuit, la membrane et l'élément de recouvrement étant disposés l'un par rapport à l'autre de telle sorte qu'au moins une cavité (14) est présente côté élément de recouvrement entre la membrane et l'élément de recouvrement,
- l'élément détecteur et le circuit de lecture étant électriquement reliés entre eux par l'intermédiaire d'une connexion électrique transversale (120) à travers la membrane et d'une liaison de matière hermétique (16), présentant une matière électroconductrice, entre la connexion électrique transversale de la membrane et le porte-circuit, la connexion transversale et le porte-circuit étant fixement assemblés entre eux par la liaison de matière, assurant ainsi un câblage électrique (123) de l'élément détecteur avec le circuit de lecture, et la liaison de matière hermétique (16) étant configurée de manière à former la cavité mise au vide (15) côté circuit et de manière à ce que la liaison de matière hermétique (16) protège d'un environnement les composants du dispositif qui se trouvent dans la cavité.

2. Dispositif selon la revendication 1, dans lequel la cavité côté élément de recouvrement est mise au vide.

3. Dispositif selon la revendication 1 ou 2, dans lequel la cavité côté circuit et la cavité côté élément de recouvrement communiquent entre elles par une ouverture (114) traversant la membrane.

4. Dispositif selon l'une des revendications 1 à 3, dans lequel la membrane, le porte-circuit et/ou l'élément de recouvrement présentent au moins une fenêtre d'irradiation (17) possédant un coefficient de transmission donné pour le rayonnement thermique, afin d'irradier l'élément détecteur avec le rayonnement thermique.

5. Dispositif selon l'une des revendications 1 à 4, dans lequel le porte-circuit et/ou l'élément de recouvrement comportent du silicium.

6. Dispositif selon l'une des revendications 1 à 5, dans lequel l'élément détecteur est disposé en vis-à-vis d'un évidement de l'élément de recouvrement.

7. Dispositif selon l'une des revendications 1 à 6, dans lequel la membrane et le porte-circuit et/ou la membrane et l'élément de recouvrement et/ou la connexion transversale et l'élément de recouvrement sont fixement assemblés entre eux par la liaison de matière (16).

8. Dispositif selon l'une des revendications 1 à 7, dans lequel au moins un réseau détecteur doté de plusieurs éléments détecteurs est présent.

9. Procédé de fabrication d'un dispositif selon l'une des revendications précédentes, comprenant les étapes suivantes :
- mise à disposition d'une membrane (11) avec un élément détecteur (111) et au moins une connexion électrique transversale (120), mise à disposition d'un porte-circuit (12) avec un circuit de lecture (121) et mise à disposition d'un élément de recouvrement (13),
- réunion de la membrane et du porte-circuit de telle sorte que l'élément détecteur et le circuit de lecture sont reliés électriquement entre eux par l'intermédiaire d'une connexion électrique transversale à travers la membrane et qu'une cavité (15) est présente côté circuit,
- réunion de la membrane et de l'élément de recouvrement de telle sorte que l'élément détecteur est tourné vers l'élément de recouvrement et est recouvert par l'élément de recouvrement, sachant que la réunion de la membrane et du porte-circuit et la réunion de la membrane et de l'élément de recouvrement créent une pile (10), la pile possédant une structure sandwich,
- assemblage fixe de la membrane et de l'élément de recouvrement par la réalisation d'une liaison de matière entre la membrane et l'élément de recouvrement, de sorte qu'une cavité (14) est présente côté élément de recouvrement,
- mise à disposition d'un support de consommable avec du matériau consommable,
- disposition de la membrane sur une partie de la surface du support de consommable et réunion de la membrane et du porte-circuit,
- élimination du matériau consommable, de sorte que la membrane est au moins partiellement mise à découvert,
- réalisation d'un perçage dans la membrane,
- remplissage du perçage avec du matériau électroconducteur, créant ainsi la connexion électrique transversale, et
- assemblage fixe de la membrane et du porte-circuit par la réalisation d'une liaison de matière hermétique (16) entre la connexion électrique transversale de la membrane et le porte-circuit, sachant que pour réaliser la liaison de matière, on applique une méthode sélectionnée dans le groupe constitué du collage, du brasage et/ou de la métallisation, et sachant que la configuration de la liaison de matière hermétique (16) engendre la formation de la cavité (15) côté circuit, de sorte que les composants du dispositif qui se trouvent dans la cavité sont protégés d'un environnement par la liaison de matière hermétique (16).

10. Procédé selon la revendication 9, dans lequel la cavité côté élément de recouvrement est mise au vide avant l'assemblage fixe.

11. Procédé selon l'une des revendications 9 à 10, dans lequel on fabrique une pluralité de dispositifs de détection de rayonnement thermique au niveau plaquette et qu'on sépare les dispositifs les uns des autres à la suite de la fabrication.
